Europäisches Patentamt

European Patent Office

Office européen des brevets

(19)

(11) **EP 1 677 417 A1**

(12) **EUROPEAN PATENT APPLICATION**
published in accordance with Art. 158(3) EPC

(43) Date of publication:
05.07.2006 Bulletin 2006/27

(21) Application number: 04817234.0

(22) Date of filing: 20.10.2004

(51) Int Cl.:
*H03F 3/24* (1968.09)        *H04B 1/04* (1968.09)

(86) International application number:
PCT/JP2004/015534

(87) International publication number:
WO 2005/039043 (28.04.2005 Gazette 2005/17)

(84) Designated Contracting States:
DE FR GB

(30) Priority: 20.10.2003 JP 2003359440
18.10.2004 JP 2004302792

(71) Applicant: **MATSUSHITA ELECTRIC INDUSTRIAL CO., LTD.**
Kadoma-shi, Osaka 571-8501 (JP)

(72) Inventors:
• **IZUMI, Takashi**
Ishikawa 920-0865 (JP)
• **IKEDA, Kazuhiko**
Ishikawa 924-0068 (JP)
• **SASAKI, Makoto**
Yokohama-shi, Kanagawa 233-0012 (JP)

(74) Representative: **Grünecker, Kinkeldey, Stockmair & Schwanhäusser Anwaltssozietät**
Maximilianstrasse 58
80538 München (DE)

(54) **AMPLIFIER CIRCUIT**

(57) A circuit capable of improving communication quality. In this circuit, constant-envelope signal generating section (101) generates a first constant-envelope signal and a second constant-envelope signal from input signals (Si, Sq). Phase-shifter (102a) shifts the phase of the first constant-envelope signal by +α° and phase-shifter (102b) shifts the phase of the second constant-envelope signal by + β°. Local signal phase-shifter (107a) shifts the phase of the local signal from local oscillator (106) by -α°, and local signal phase-shifter (107b) shifts the phase of the local signal from local oscillator (106) by -β°. Mixers (103a, 103b) performs frequency-conversion of the first constant-envelope signal and the second constant-envelope signal from phase shifters (102a, 102b) using the local signals from local signal phase-shifters (107a, 107b). Amplifiers (104a, 104b) amplify signals from mixers (103a, 103b). Combining circuit (105) combines signals from amplifiers (104a, 104b).

FIG.4

**Description**

Technical Field

The present invention relates to an amplifier circuit, and particularly relates to a final stage amplifier circuit amplifying a transmission signal in a transmission apparatus employed in wireless communication and broadcasting.

Background Art

In recent years, cases of transmitting digitally modulated signals in a transmission apparatus employed in wireless communication and broadcasting are commonplace. It is therefore required for amplifier circuits employed in a transmission apparatus to attain linearity, because multi-value techniques have been developed for most of such signals and have enabled information to be carried on an amplitude direction. On the other hand, high power efficiency is required at the amplifier circuit in order to curtail power consumption of the apparatus. Various techniques have been proposed for compensating for distortion and improving efficiency in order to combine linearity and power efficiency of the amplifier circuit. One system referred to as the LINC (Linear Amplification with Nonlinear Components) system exists as a system for an amplifier circuit of the conventional art. In this system, the transmission signal is divided into two constant-envelope signals, is amplified by a non-linear amplifier of high power efficiency, is then combined, and thereby both linearity and transmission efficiency are achieved.

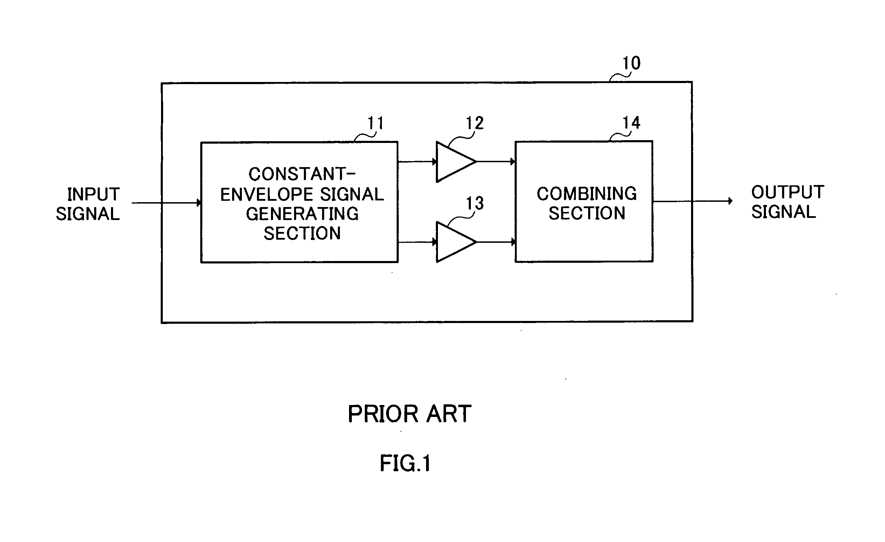

Here, a description is given using FIG.1 of a typical example of an amplifier circuit employing the LINC system. In an amplifier circuit 10 shown in FIG.1, at a constant-envelope signal generating section 11, two constant-envelope signals Sa (t) and Sb (t) are generated from an input signal S(t). For example, assuming the constant-envelope signals Sa(t) and Sb(t) is given by the following (equation 2) and (equation 3) when the input signal S(t) is represented by the following (equation 1), each constant-envelope signal Sa(t) and Sb(t) is constant in the amplitude direction.

$$S(t) = V(t) \times \cos\{\omega ct + \varphi(t)\} \ldots (equation\ 1)$$

Where the maximum value for V (t) is Vmax, and the angular frequency of the carrier for the input signal is ωc.

$$Sa(t) = Vmax/2 \times \cos\{\omega ct + \psi(t)\} \ldots (equation\ 2)$$

$$Sb(t) = Vmax/2 \times \cos\{\omega ct + \theta(t)\} \ldots (equation\ 3)$$

Where

$$\psi(t) = \varphi(t) + \alpha(t), \quad \theta(t) = \varphi(t) - \alpha(t).$$

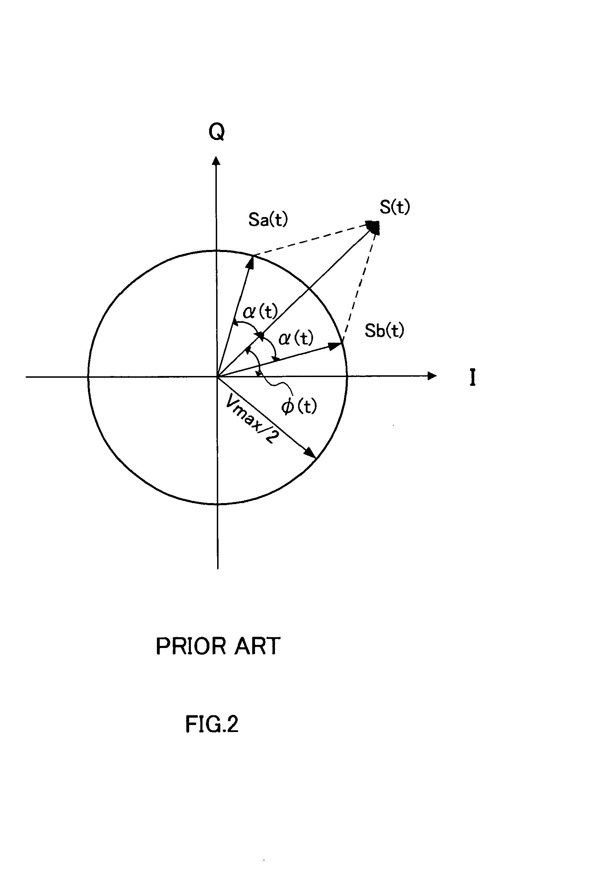

In FIG.2, the operation of generating the constant-envelope signals is shown using signal vectors on orthogonal plane coordinates, and as shown in this figure, the input signal S (t) is represented as the vector sum of the two constant-envelope signals Sa(t), Sb(t) of which amplitude is Vmax/2.

Now refer again to FIG.1. The two constant-envelope signals are respectively amplified by two amplifiers 12, 13. At this time, assuming a gain of amplifiers 12, 13 is G, output signals of amplifiers 12, 13 are G×Sa (t) and G×Sb (t), respectively. At combining section 14, when the output signals G×Sa (t) and G×Sb(t) are combined, an output signal G×S(t) is obtained.

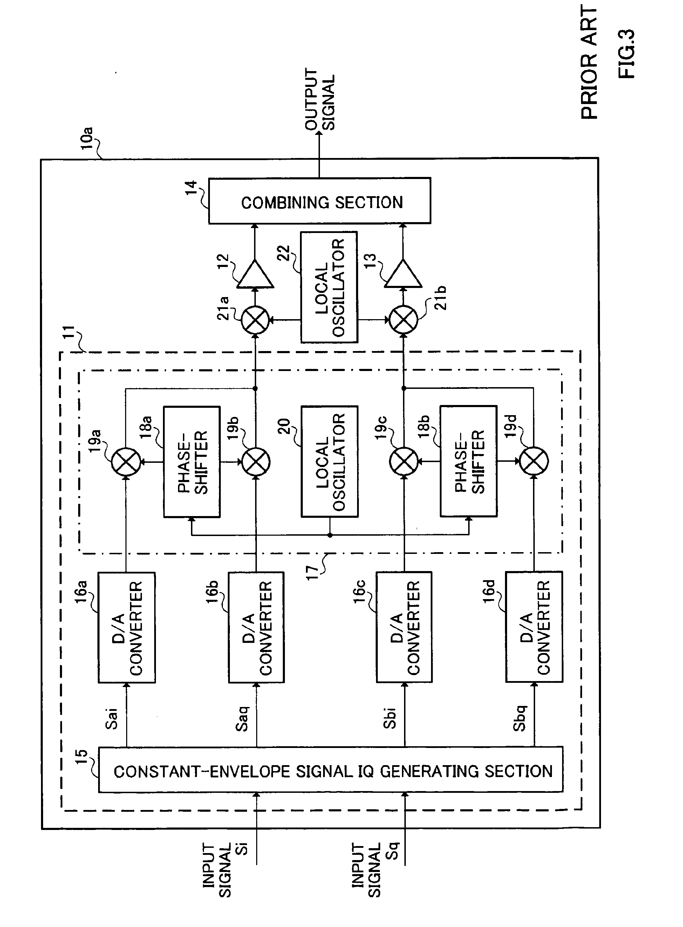

Heretofore, amplifier circuits as described above are described for example in patent document 1 and patent document 2. An example of a detailed configuration of an amplifier circuit for implementing the LINC system is shown in FIG.3. At amplifier circuit 10a shown in FIG.3, baseband signals Sai, Saq, Sbi, Sbq, which constitute constant-envelope signals Sa, Sb after orthogonal demodulation, are generated from baseband input signals Si, Sq by digital signal processing at constant-envelope signal IQ generating section 15. Then, after each baseband signal is converted to an analog signal using D/A converters 16a, 16b, 16c, 16d, and the signals are orthogonally modulated by orthogonal modulator 17 having two orthogonal modulators to obtain two constant-envelope signals Saif, Sbif. Then, at mixer 21a, 21b, frequency conversion is carried out by mixing each signal with a local signal supplied by local oscillator 22 to obtain signals Sarf, Sbrf converted to a carrier frequency. Final amplification is then carried out at amplifiers 12, 13, and combining is carried out at combining section 14 to obtain an output signal as a result.

Patent Document 1: Japanese Patent Laid-open Publication No. Hei. 6-22302.
Patent Document 2: Japanese Patent Laid-open Publication No. Hei. 8-163189.

Disclosure of Invention

Problems to be Solved by the Invention

However, with the conventional amplifier circuit, leakage of the local signal used at mixers 21a, 21b occurs when frequency conversion is carried out at mixers 21a, 21b. The leaked local signal then constitutes spurious components that could harm the communication quality.

One of the techniques for suppressing the leakage of the local signal is to use filters. However, in general, in a typical LINC system amplifier circuit, an original input signal is converted into two phase-modulated constant-envelope signals, and the spectrum of the processed signals is spread in the frequency direction. Because of this, there have been problems of loss of modulated information, increased distortion of transmission signal, deterioration of the communication quality upon suppressing the leakage of the local signal using filters.

It is therefore the object of the present invention to provide a high power efficiency amplifier circuit capable of improving communication quality.

Means for Solving the Problem

The amplifier circuit of the present invention adopts a configuration comprising a generating section that generates a first local signal and a second local signal which are used in frequency conversion of a first constant-envelope signal and a second constant-envelope signal having respective predetermined phases, the first local signal and the second local signal having a 180° phase difference therebetween, a frequency conversion section that performs frequency-conversion of the first constant-envelope signal and the second constant-envelope signal using the generated first local signal and second local signal, an amplifying section that amplifies the frequency-converted first constant-envelope signal and second constant-envelope signal, and a combining section that combines the amplified first constant-envelope signal and second constant-envelope signal.

Advantageous Effect of the Invention

As described above, according to the present invention, it is possible to improve communication quality.

Brief Description of the Drawings

FIG.1 is a view showing a typical example of a configuration for a conventional amplifier circuit.
FIG.2 is a vector diagram showing an operation of a conventional amplifier circuit on orthogonal plane coordinates.
FIG.3 is a view showing an example of a detailed configuration of a conventional amplifier circuit.
FIG.4 is a block diagram showing a configuration of an amplifier circuit of a first embodiment of the present invention.
FIG. 5A is a vector diagram showing phase-shift processing of each constant-envelope signal of the first embodiment of the present invention.
FIG. 5B is a vector diagram showing phase-shift processing of a local signal of the first embodiment of the present invention.
FIG. 5C is a vector diagram showing a signal after combining of the first embodiment of the present invention.
FIG.6 is a block diagram showing a configuration of an amplifier circuit of a second embodiment of the present invention.
FIG.7 is a block diagram showing a configuration of an amplifier circuit of a third embodiment of the present invention.
FIG.8 is a block diagram showing a configuration of an amplifier circuit of a fourth embodiment of the present invention.
FIG.9 is a block diagram showing a configuration of an amplifier circuit of a fifth embodiment of the present invention.
FIG.10 is a block diagram showing a configuration of an amplifier circuit of a sixth embodiment of the present invention.
FIG.11 is a block diagram showing a configuration of an amplifier circuit of a seventh embodiment of the present invention.

FIG.12 is a block diagram showing a configuration of an amplifier circuit of an eighth embodiment of the present invention.

FIG.13 is a block diagram showing a configuration of a wireless transceiver apparatus of a ninth embodiment of the present invention.

FIG.14 is a block diagram showing a configuration of an amplifier circuit of a tenth embodiment of the present invention.

FIG.15 is a view showing a signal waveform obtained at each processing stage of the amplifier circuit of the tenth embodiment of the present invention.

FIG.16 is a block diagram showing a configuration of an amplifier circuit of an eleventh embodiment of the present invention.

FIG.17 is a block diagram showing a configuration of a wireless transceiver apparatus of a twelfth embodiment of the present invention.

Best Mode for Carrying Out the Invention

The following is a detailed description of embodiments of the present invention using the drawings.

(First Embodiment)

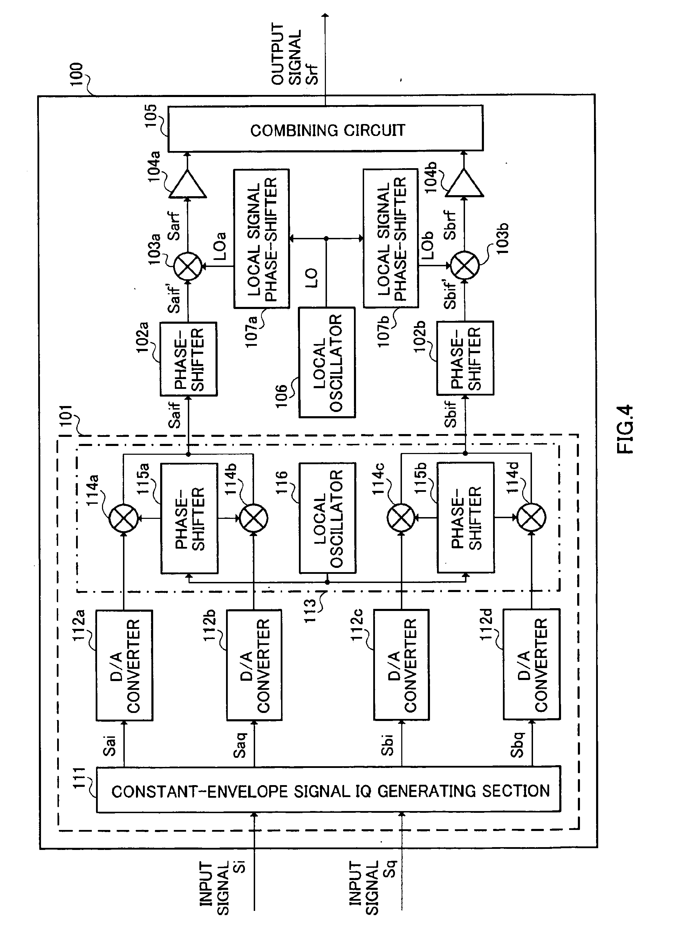

FIG.4 is a block diagram showing a configuration for an amplifier circuit of a first embodiment of the present invention.

Amplifier circuit 100 shown in FIG.4 is comprised of constant-envelope signal generating section 101, two phase-shifters 102a, 102b, two mixers 103a, 103b, two amplifiers 104a, 104b, combining circuit 105, local oscillator 106, and two local signal phase-shifters 107a, 107b.

Further, constant-envelope signal generating section 101 is comprised of constant-envelope signal IQ generating section 111, four D/A (Digital to Analog) converters 112a, 112b, 112c, 112d, and orthogonal modulator 113. Orthogonal modulator 113 has four mixers 114a, 114b, 114c, 114d, two phase-shifters 115a, 115b, and local oscillator 116.

Constant-envelope signal generating section 101 generates two constant-envelope signals, i.e. a first constant-envelope signal Saif and second constant-envelope signal Sbif, which are equivalent to signals obtained by orthogonally modulating the input signals Si, Sq using a carrier frequency of a predetermined frequency at the time of vector combining, using baseband input signals Si, Sq, and outputs these signals respectively to two phase-shifters 102a, 102b. The constant-envelope signal generating section 101 may also be implemented using a digital signal processing circuit such as an ASIC (Application Specific Integrated Circuit) or FPGA (Field Programmable Gate Array).

More specifically, in constant-envelope signal generating section 101, constant-envelope signal IQ generating section 111 carries out digital signal processing on input signals Si, Sq, and generates baseband signals Sai, Saq, Sbi, Sbq. Constant-envelope signal IQ generating section 111 is, for example, a digital signal processing circuit such as an ASIC or FPGA, or the like.

D/A converters 112a to 112d convert baseband signals Sai, Saq, Sbi, Sbq respectively from digital to analog signals. D/A converters 112a to 112d are, for example, digital to analog converter ICs (Integrated Circuits) converting digital signals to analog signals.

Orthogonal modulator 113 orthogonally modulates baseband signals Sai, Saq, Sbi, Sbq converted to analog signals, generates first constant-envelope signal Saif and second constant-envelope signal Sbif, and outputs these signals to phase-shifters 102a, 102b, respectively. Local oscillator 116 in orthogonal modulator 113 is an oscillation circuit such as a frequency synthesizer or the like employing a voltage controlled oscillator (VCO) controlled by a phase-locked loop (PLL). Further, phase-shifters 115a, 115b in orthogonal modulator 113 are, for example, hybrid phase-shifters using microstrip lines.

Phase-shifter 102a changes the phase of first constant-envelope signal Saif from orthogonal modulator 113 by $+\alpha°$ and generates phase-shifted first constant-envelope signal Saif'. Phase-shifter 102b changes the phase of second constant-envelope signal Sbif from orthogonal modulator 113 by $+\beta°$ and generates phase-shifted second constant-envelope signal Sbif'. Here, $|\alpha-\beta|=180$. Further, phase-shifters 102a, 102b are, for example, hybrid phase-shifters using microstrip lines.

Mixer 103a performs frequency conversion (up-conversion) by mixing first constant-envelope signal Saif' from phase-shifter 102a with local signal LOa from local signal phase-shifter 107a, and generates frequency-converted first constant-envelope signal Sarf. Mixer 103b performs frequency conversion (up-conversion) by mixing second constant-envelope signal Sbif' from phase-shifter 102b with local signal LOb from local signal phase-shifter 107b, and generates frequency-converted second constant-envelope signal Sbrf.

Local oscillator 106 is, for example, an oscillator circuit such as a frequency synthesizer or the like employing a VCO controlled by a PLL, generates local signal LO, and outputs this to local signal phase-shifters 107a, 107b.

Local signal phase-shifter 107a changes the phase of local signal LO from local oscillator 116 by $-\alpha°$ and generates phase-converted local signal LOa. Local signal phase-shifter 107b changes the phase of local signal LO from local oscillator 116 by -β° and generates phase-converted local signal LOb. Local signal phase-shifters 107a, 107b are, for example, hybrid phase-shifters using microstrip lines.

Amplifier104aamplifiesfirstconstant-envelope signal Sarf from mixer 103a and outputs this to combining circuit 105. Amplifier 104b amplifies second constant-envelope signal Sbrf from mixer 103b and outputs this to combining circuit 105. Amplifiers 104a, 104b are configured from, for example, FETs (Field Effect Transistors) and transistors.

Combining circuit 105 is a Wilkinson-type combining circuit or resistor combining circuit configured from microstrip lines and generates output signal Srf, which is a signal outputted from amplifier circuit 100, by combining first constant-envelope signal Sarf and second constant-envelope signal Sbrf amplified by amplifiers 104a, 104b.

Next, an operation of amplifier circuit 100having the above configuration is described. Here, a description is given of the case where input signal S(t) is transmitted at carrier frequency ωrf.

First, in constant-envelope signal generating section 101, two constant-envelope signals, i.e. a first constant-envelope signal Saif and second constant-envelope signal Sbif, which are equivalent to signals obtained by orthogonally modulating input signals Si, Sq using a carrier frequency ωrf of a predetermined frequency at the time of vector combining, from baseband input signals Si, Sq, are generated, and respectively outputted to two phase-shifters 102a, 102b. Input signal S(t) can be expressed by the following (equation 4).

$$S(t)=Saif+Sbif=Vmax/2·cos(ωift+ψ(t))$$
$$+Vmax/2·cos(ωift+θ(t))...(equation\ 4)$$

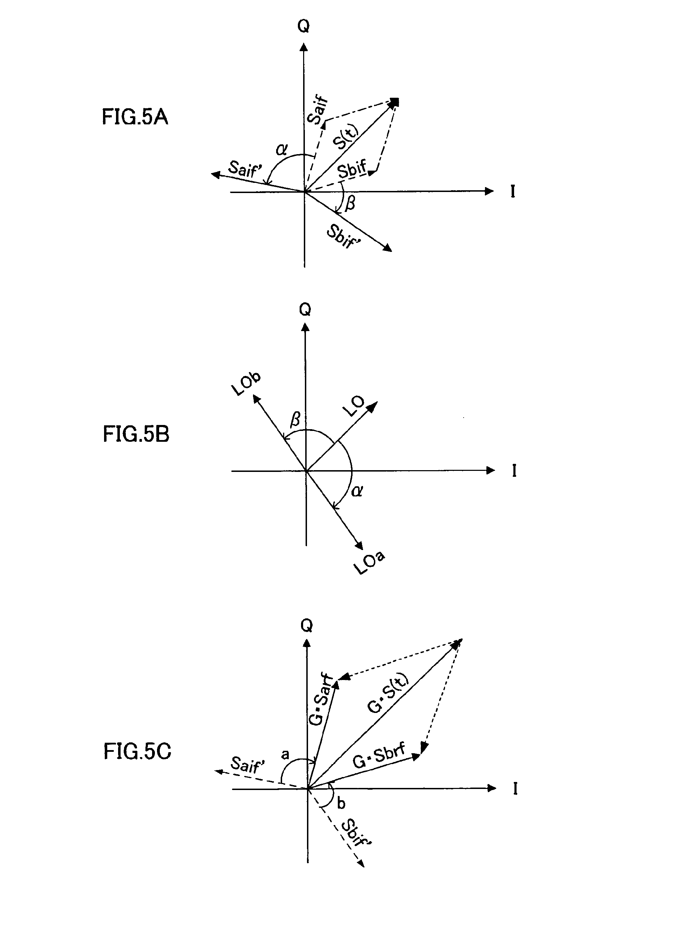

In phase-shifter 102a to which first constant-envelope signal Saif is inputted, the phase of first constant-envelope signal Saif is changed by +α°, and in phase-shifter 102b to which second constant-envelope signal Sbif is inputted, the phase of second constant-envelope signal Sbif is changed by +β°. First constant-envelope signal Saif' and second constant-envelope signal Sbif' after phase-shift processing are outputted to mixers 103a, 103b, respectively. These phase-shifting processes are expressed by the following (equation 5) and (equation 6). FIG.5A is a vector diagram showing phase-shift processing for each constant-envelope signal.

$$Saif'=Vmax/2·cos(ωift+ψ(t)+α)...(equation\ 5)$$

$$Sbif'=Vmax/2·cos(ωift+θ(t)+β)...(equation\ 6)$$

Further, for local signal LO outputted from local oscillator 106, its phase is changed by -α° at local signal phase-shifter 107a, and local signal LO becomes local signal LOa to be used at mixer 103a to which first constant-envelope signal Saif' is inputted. Moreover, for local signal LO, its phase is changed by -β° at local signal phase-shifter 107b, and local signal LO become local signal LOb to be used at mixer 103b to which second constant-envelope signal Sbif' is inputted. Generated local signals LOa, LOb are respectively expressed by (equation 7) and (equation 8). For simplicity, the amplitude of local signal LO in this example is assumed to be "1". FIG. 5B is a vector diagram showing phase-shift processing for the local signal.

$$LOa=cos(ωLOt-α)...(equation\ 7)$$

$$LOb=cos(ωLOt-β)...(equation\ 8)$$

Mixing of first constant-envelope signal Saif' and local signal LOa is carried out at mixer 103a, and frequency-converted first constant-envelope signal Sarf and the leakage of local signal LOa are outputted from mixer 103a and inputted to amplifier 104a.

Mixing of second constant-envelope signal Sbif' and local signal LOb is carried out at mixer 103b, and frequency-converted second constant-envelope signal Sbrf and the leakage of local signal LOb are outputted from mixer 103b and inputted to amplifier 104b.

Here, first constant-envelope signal Sarf and second constant-envelope signal Sbrf are expressed by (equation 9) and (equation 10), respectively.

$$Sarf = Vmax/2 \cdot \cos((\omega LO + \omega if)t + \psi(t) + \alpha - \alpha)$$

$$= Vmax/2 \cdot \cos(\omega rft + \psi(t)) \ldots (equation\ 9)$$

$$Sbrf = Vmax/2 \cdot \cos((\omega LO + \omega if)t + \theta(t) + \beta - \beta)$$

$$= Vmax/2 \cdot \cos(\omega rft + \theta(t)) \ldots (equation\ 10)$$

Further, the leakage of local signal LOa and the leakage of local signal LOb are expressed by (equation 11) and (equation 12), respectively.

$$LOa = \cos(\omega LOt - \alpha) \ldots (equation\ 11)$$

$$LOb = \cos(\omega LOt - \beta) \ldots (equation\ 12)$$

Amplification of the inputted signals is carried out at amplifier 104a, 104b, and the results are outputted to combining circuit 105. In combining circuit 105, the inputted signals are combined and the result is outputted. Assuming a gain of amplifier 104a, 104b to be G, first constant-envelope signal Sarf and second constant-envelope signal Sbrf are expressed by (equation 13) and (equation 14), respectively.

$$Sarf = G \cdot Vmax/2 \cdot \cos((\omega rft + \psi(t)) \ldots (equation\ 13)$$

$$Sbrf = G \cdot Vmax/2 \cdot \cos((\omega rft + \theta(t)) \ldots (equation\ 14)$$

The signal after combining of first constant-envelope signal Sarf and second constant-envelope signal Sbrf can then be expressed by the following (equation 15) based on the relationship shown in (equation 1) (equation 2), and (equation 3). FIG.5C is a vector diagram of the signal after combining of first constant-envelope signal Sarf and second constant-envelope signal Sbrf.

$$Sarf + Sbrf = G \cdot (Vmax/2 \cdot \cos((\omega rft + \psi(t))$$

$$+ Vmax/2 \cdot \cos((\omega rft + \theta(t)))) \ldots (equation\ 15)$$

On the other hand, the leakages of local signals LOa, LOb after amplification is expressed in (equation 16) and (equation 17), respectively.

$$LOa = G \cdot \cos(\omega LOt - \alpha) \ldots (equation\ 16)$$

$$LOb=G \cdot cos(\omega LOt - \beta) \quad ... \quad (equation\ 17)$$

Further, the signal after combining of the leakages of local signals LOa, LOb can be expressed by (equation 18).

$$LOa+LOb=G \cdot cos(\omega LOt - \alpha)+G \cdot cos(\omega LOt - \beta)$$

$$=G \cdot (cos(\omega LOt)cos(\alpha)-sin(\omega LOt)sin(\alpha)$$

$$+cos(\omega LOt)cos(\beta)-sin(\omega LOt)sin(\beta))$$

$$=G \cdot (cos(\omega LOt) \cdot (2 \cdot cos((\alpha+\beta)/2) \cdot cos((\alpha-\beta)/2))$$

$$-sin(\omega LOt) \cdot (2 \cdot ((sin((\alpha+\beta)/2) \cdot cos((\alpha-\beta)/2)))$$

$$... (equation\ 18)$$

As described above, as $|\alpha-\beta|=180$, in (equation 18) above, $cos((\alpha-\beta)/2)=0$, and the solution of (equation 18) is "0".

Looking at the output signal of combining circuit 105, regarding the constant-envelope signal, it is understood from (equation 15) that a signal obtained by amplifying input signal S (t) by a factor of G is outputted with carrier frequency ωrf. On the other hand, it can also be understood from (equation 18) that the leakage of the local signals frommixers 103a, 103b after combining becomes "0" and is not outputted from combining circuit 105.

According to this embodiment, the phase difference of two local signals used in frequency conversion of two constant-envelope signals is made to be 180° and the phase is changed beforehand so as to return to its original state after frequency conversion, and therefore, it is possible to suppress the leakage of the local signal without increasing the distortion of the signal, outputted from combining circuit 105, in other words the transmission signal, and to improve the communication quality with high power efficiency.

In this embodiment, a configuration is adopted where phase-shifters 102a, 102b are provided at a stage after constant-envelope signal generating section 101 but this configuration is by no means limiting. For example, a configuration may also be adopted where items executing the same operation as phase-shifters 102a, 102b are provided at the output of local oscillator 116 within orthogonal modulator 113 in order to change the phase of the local signal using orthogonal modulator 113, and such a configuration makes it possible to obtain the same operation and effect as mentioned above.

Further, in this embodiment, a configuration is adopted where local signal phase-shifters 107a, 107b are arranged between local oscillator 106 and mixers 103a, 103b but this configuration is by no means limiting. For example, it is possible to obtain the same operation and effect as above even if items executing the same operation as local signal phase-shifters 107a, 107b are arranged between mixers 103a, 103b and combining circuit 105, or within combining circuit 105.

(Second Embodiment)

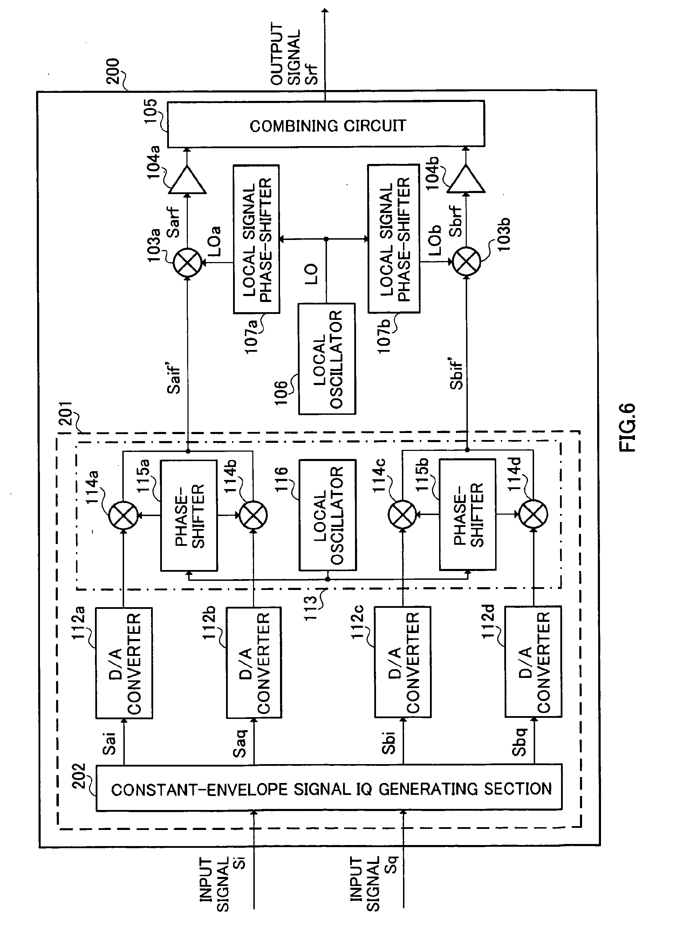

FIG.6 is a block diagram showing a configuration for an amplifier circuit of a second embodiment of the present invention. The amplifier circuit described in this embodiment has a basic configuration similar to amplifier circuit 100 described in the first embodiment, the same reference numerals are assigned to the same structural elements, and detailed description thereof is therefore omitted.

Amplifier circuit 200 shown in FIG.6 is provided with constant-envelope signal generating section 201 in place of constant-envelope signal generating section 101 shown in FIG.4 and adopts a configuration where phase-shifters 102a, 102b of amplifier circuit 100 are not provided. Constant-envelope signal generating section 201 adopts a configuration of providing constant-envelope signal IQ generating section 202 in place of constant-envelope signal IQ generating section 111 of constant-envelope signal generating section 101.

Constant-envelope signal generating section 201 generates two constant-envelope signals, i.e. first constant-envelope signal Saif' and second constant-envelope signal Sbif', which are equivalent to signals obtained by orthogonally modulating input signals Si, Sq using a carrier frequency of a predetermined frequency at the time of vector combining, using baseband input signals Si, Sq, and outputs these signals respectively to mixer 103a, 103b. Constant-envelope signal generating section 201 may also be implemented using a digital signal processing circuit such as an ASIC or FPGA.

At constant-envelope signal generating section 201, constant-envelope signal IQ generating section 202 carries out digital signal processing on IQ signals (i.e. input signals Si, Sq) of input signal S(t), as shown in the following (equation 19) and (equation 29), and in such a manner that the phase of first constant-envelope signal Saif' after orthogonal modulation is changed by $+\alpha°$, and thereby generates baseband signals Sai, Saq. Further, constant-envelope signal IQ generating section 202 carries out digital signal processing to IQ signals of input signal S(t), as shown in the following (equation 21) and (equation 22), and in such a manner that the phase of second constant envelop signal Sbif' is changed by $+\beta°$, and thereby generates baseband signals Sbi, Sbq. Constant-envelope signal IQ generating section 202 is, for example, a digital signal processing circuit such as an ASIC or FPGA, or the like.

$$Sai = ((I - Q \cdot SQRT(x/a^2 - 1)) \cdot \cos\alpha$$
$$- (Q + I \cdot SQRT(x/a^2 - 1)) \cdot \sin\alpha \quad ...(equation\ 19)$$

$$Saq = ((Q + I \cdot SQRT(x/a^2 - 1)) \cdot \cos\alpha$$
$$+ (I - Q \cdot SQRT(x/a^2 - 1)) \cdot \sin\alpha \quad ...(equation\ 20)$$

$$Sbi = ((I + Q \cdot SQRT(x/a^2 - 1)) \cdot \cos\beta$$
$$- (Q - I \cdot SQRT(x/a^2 - 1)) \cdot \sin\beta \quad ...(equation\ 21)$$

$$Sbq = ((Q - I \cdot SQRT(x/a^2 - 1)) \cdot \cos\beta$$
$$- (I + Q \cdot SQRT(x/a^2 - 1)) \cdot \sin\beta \quad ...(equation\ 22)$$

where SQRT $(x/a^2 - 1)$ is the square root of $x/a^2 - 1$, $a^2 = I^2 + Q^2$, and x denotes the maximum value of a.

Here, a detailed description is given of processing at constant-envelope signal IQ generating section 202 using arithmetic expressions.

In a typical constant-envelope signal IQ generating section, as shown in patent document 1 or patent document 2 described above, IQ signals (i.e. Sai and Saq) of first constant-envelope signal Sa(t) and IQ signals (i.e. Sbi and Sbq) of second constant-envelope signal Sb(t) are generated from the IQ signals of the original input signal S(t) according to the following (equation 23), (equation 24), (equation 25) and (equation 26).

$$Sai = ((I - Q \cdot SQRT(x/a^2 - 1)) \quad ...(equation\ 23)$$

$$Saq = ((Q + I \cdot SQRT(x/a^2 - 1)) \quad ...(equation\ 24)$$

$$Sbi = ((I + Q \cdot SQRT(x/a^2 - 1)) \quad ...(equation\ 25)$$

$$Sbq = ((Q - I \cdot SQRT(x/a^2 - 1)) \quad ...(equation\ 26)$$

First constant-envelope signal Sa(t) and second constant-envelope signal Sb(t) are signals obtained by orthogonally modulating Sai and Saq and orthogonally modulating Sbi and Sbq, respectively. These relationships are shown as arithmetic expressions in the following (equation 27) and (equation 28).

$$Sa(t)=Sai+j \cdot Saq...(equation\ 27)$$

$$Sb(t)=Sbi+j \cdot Sbq...(equation\ 28)$$

An equation expressing shifting of the phase of Sa(t) by $+\alpha°$ and shifting of the phase of Sb(t) by $+\beta°$ as described above is as shown in the following.

$$Sa'(t)=(Sai+j \cdot Saq) \cdot (cos\alpha+j \cdot sin\alpha)...(equation\ 29)$$

$$Sb'(t)=(Sbi+j \cdot Sbq) \cdot (cos\beta+j \cdot sin\beta)...(equation\ 30)$$

Namely, if the real part of (equation 29) is selected as Sai and the imaginary part as Saq and orthogonal modulation is carried out, the signal after orthogonal modulation is a signal obtained by changing the phase of the first constant-envelope signal by $+\alpha°$. This is expressed in the form of an equation in (equation 19) and (equation 20). Similarly, if the real part of (equation 30) is selected as Sbi and the imaginary part as Sbq and orthogonal modulation is carried out, the signal after orthogonal modulation is a signal obtained by changing the phase of the second constant-envelope signal by $+\beta°$. This is expressed in the form of an equation in (equation 21) and (equation 22).

Namely, if constant-envelope signal IQ generating section 202 generates the IQ signals of baseband signals Sa(t), Sb(t) from the IQ signals of the original input signal S (t) by carrying out the processing of (equation 19) to (equation 22) described above, and orthogonal modulator 113 performs orthogonal modulation correspondingly, first constant-envelope signal Saif' inputted to mixer 103a is a signal with its phase shifted by $+\alpha°$, and second constant-envelope signal Sbif' inputted to mixer 103b is a signal with its phase shifted by $+\beta°$, so that it is possible to change the phase of the two constant-envelope signals without using phase-shifters.

According to this embodiment, phase-shifters 102a, 102b described in the first embodiment are not necessary. It is therefore possible to suppress the leakage of the local signal without increasing the distortion of the transmission signal while achieving miniaturization of amplifier circuit 200. In addition, it is possible to change the phase using digital signal processing without using phase-shifters, which makes it possible to improve the precision of the phase change in comparison with analog phase-shifters.

(Third Embodiment)

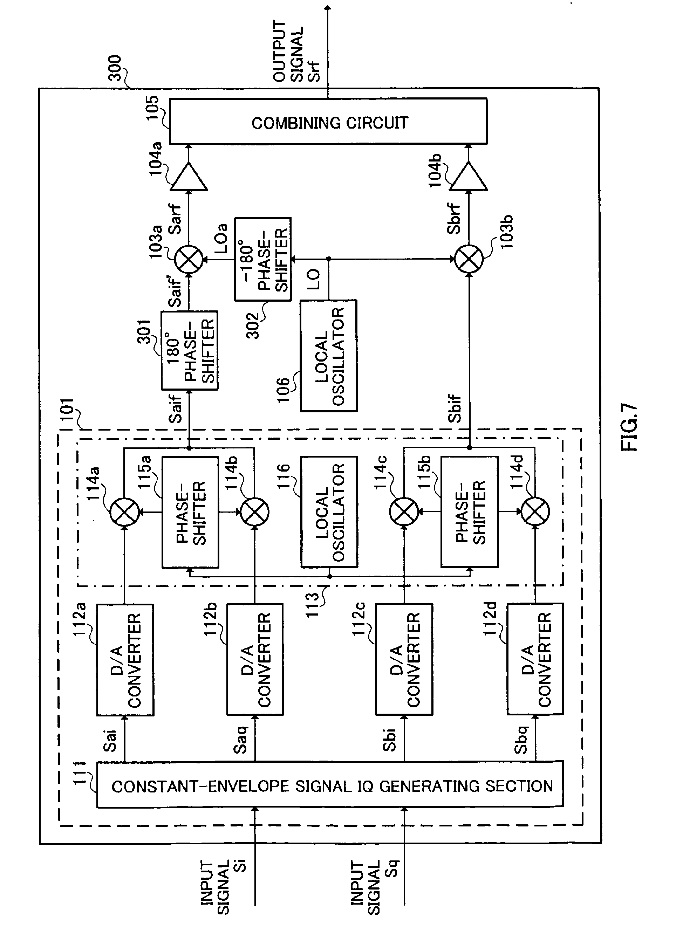

FIG.7 is a block diagram showing a configuration for an amplifier circuit of a third embodiment of the present invention. The amplifier circuit described in this embodiment has a basic configuration similar to amplifier circuit 100 described in the first embodiment, the same reference numerals are assigned to the same structural elements, and detailed description thereof is therefore omitted.

Amplifier circuit 300 shown in FIG.7 adopts a configuration where 180° phase-shifter 301 and -180° phase-shifter 302 are provided in place of phase-shifter 102a and local signal phase-shifter 107a of amplifier circuit 100 shown in FIG.4 and phase-shifter 102b and local signal phase-shifter 107b of amplifier circuit 100 are not provided.

180° phase-shifter 301 changes the phase of first constant-envelope signal Saif from orthogonal modulator 113 by +180° to generate phase-shifted first constant-envelope signal Saif'. In addition, 180° phase-shifter 301 is, for example, a hybrid phase-shifter using microstrip lines.

-180° phase-shifter 302 changes the phase of local signal LO from local oscillator 106 by -180° to generate phase-converted local signal LOa. Further, -180° phase-shifter 302 is, for example, a hybrid phase-shifter using microstrip lines.

Namely, amplifier circuit 300 of this embodiment executes an operation similar to the case of taking $\alpha$ = 180 and $\beta$ = 0 in amplifier circuit 100 of the first embodiment.

Therefore, in a path through which the first constant-envelope signal passes, the phase of first constant-envelope signal Saif is shifted by +180° at 180° phase-shifter 301, and first constant-envelope signal Saif' is outputted to mixer 103a. At mixer 103a, frequency conversion is carried out using local signal LOa phase-shifted by -180° at -180° phase-shifter 302. As a result, signals outputted to amplifier 104a are first constant-envelope signal Sarf of a phase that is the same as the original signal, and the leakage of local signal LOa of a phase changed by -180° . On the other hand, since a phase-shifter is not provided in the path through which the second constant-envelope signal passes, the amount of phase-change of second constant-envelope signal Sbif and local signal LO is 0°.

The two constant-envelope signals which have passed through amplifiers 104a, 104b are then combined by combining circuit 105, and an amplified desired transmission signal (output signal Srf) is outputted. The leakage of the local signal is therefore suppressed because the phase difference between local signal LO and local signal LOa is 180°.

According to this embodiment, phase-shifters 102b and local signal phase-shifter 107b described in the first embodiment are not necessary. It is therefore possible to suppress the leakage of the local signal without increasing the distortion of the transmission signal while achieving miniaturization of amplifier circuit 300.

In this embodiment, a description is given of a configuration of amplifier circuit 300 where 180° phase-shifter 301 and -180° phase-shifter 302 are provided in place of phase-shifter 102a and local signal phase-shifter 107a of amplifier circuit 100 shown in FIG.4 and phase-shifter 102b and local signal phase-shifter 107b of amplifier 100 are not provided, but the configuration of the amplifier circuit 300 is by no means limited to this respect. For example, the same operation and effect as described above can also be obtained by adopting a configuration where 180° phase-shifter 301 and -180° phase-shifter 302 are provided in place of phase-shifter 102b and local signal phase-shifter 107b and phase-shifter 102a and local signal phase-shifter 107a of amplifier circuit 100 are not provided.

(Fourth Embodiment)

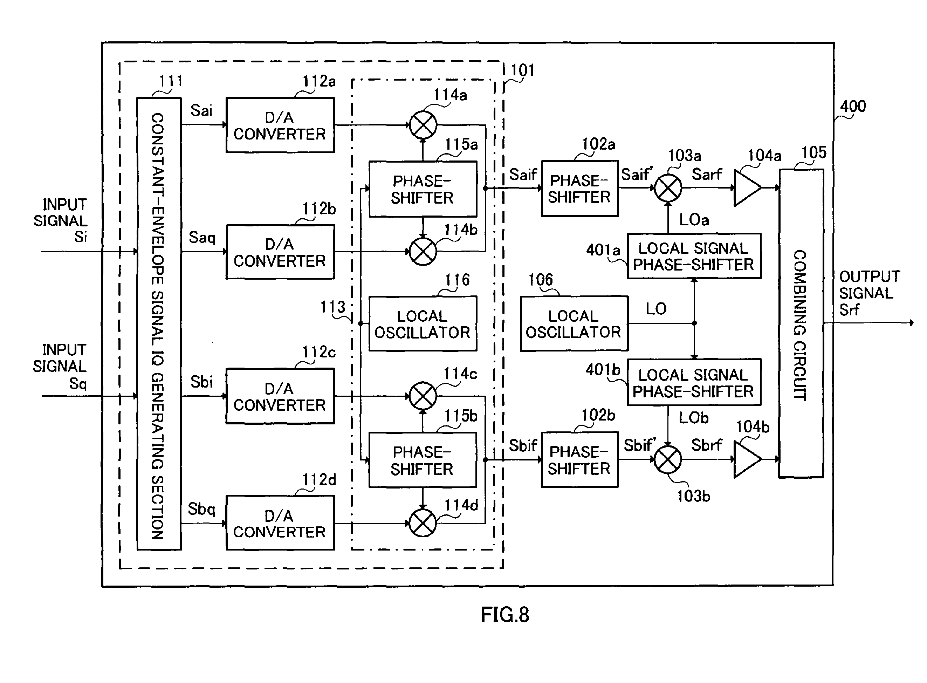

FIG.8 is a block diagram showing a configuration for an amplifier circuit of a fourth embodiment of the present invention. The amplifier circuit described in this embodiment has a basic configuration similar to amplifier circuit 100 described in the first embodiment, the same reference numerals are assigned to the same structural elements, and detailed description thereof is therefore omitted.

Amplifier circuit 400 shown in FIG.8 adopts a configuration where variable phase-shifters 401a, 401b are provided in place of local signal phase-shifters 107a, 107b of amplifier circuit 100 shown in FIG.4.

Variable phase-shifters 401a, 401b differ from local signal phase-shifters 107a, 107b in having a function to adjust an amount of change of phase of local signal LO.

Next, an operation of amplifier circuit 400 having the above configuration is described.

In the event that an electrical length is different between two paths through which the local signal passes (i.e. paths from local oscillator 106 through mixers 103a, 103b to combining circuit 105), or in the event that there is a difference in an amount of phase-change by each amplifier 104a, 104b or mixer 103a, 103b, errors occur in the phase difference between the leakages of local signal LOa and local signal LOb so that the phase difference is no longer 180°. Variable phase-shifters 401a, 401b adjust the amount of phase-change, and therefore, it is possible to reduce phase difference errors and prevent lowering the amount of suppression of leakage of the local signal.

According to this embodiment, adjusting the amount of phase-change of the local signal used in frequency conversion at mixers 103a, 103b makes it possible to reduce errors in phase difference due to electrical length differences or the like occurring in paths through which the local signal passes, and also makes it possible to prevent lowering of the amount of suppression of leakage of the local signal.

In this embodiment, a description is given of a configuration where variable phase-shifters 401a, 401b are arranged between local oscillator 106 and mixers 103a, 103b but the configuration of amplifier circuit 400 is by no means limited to this respect. For example, it is possible to obtain the same operation and effect as above even if items executing the same operation as variable phase-shifters 401a, 401b are arranged between mixers 103a, 103b and combining circuit 105, or within combining circuit 105.

(Fifth Embodiment)

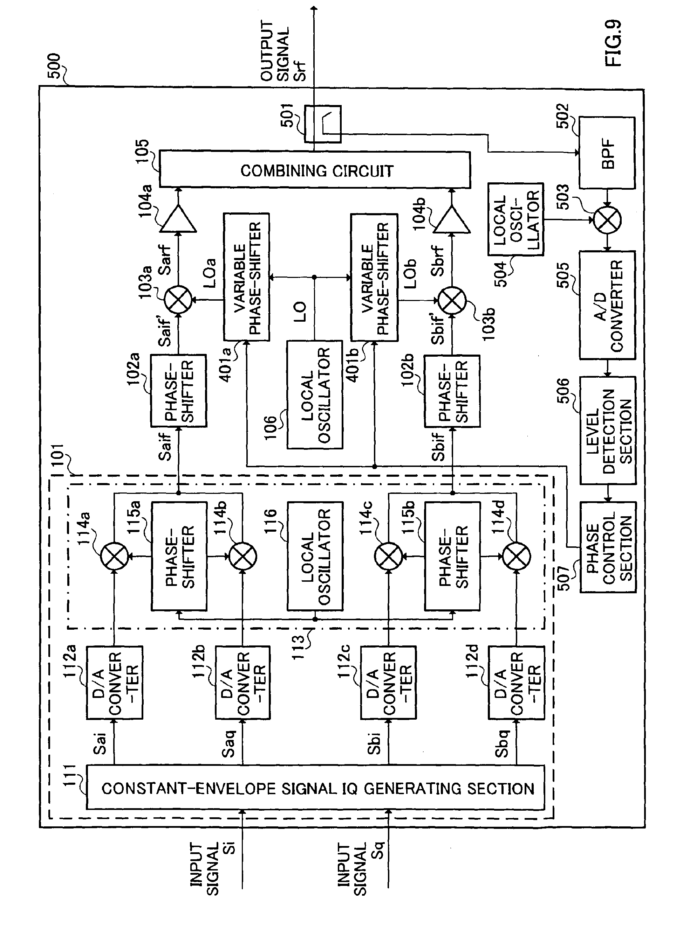

FIG.9 is a block diagram showing a configuration for an amplifier circuit of a fifth embodiment of the present invention. The amplifier circuit described in this embodiment has a basic configuration similar to amplifier circuit 100 described in the first embodiment, the same reference numerals are assigned to the same structural elements, and detailed description thereof is therefore omitted.

Amplifier circuit 500 shown in FIG.9 adopts a configuration where signal detection section 501, band pass filter (BPF) 502, mixer 503, local oscillator 504, A/D converter 505, level detection section 506, and phase control section 507 are added to the configuration of amplifier circuit 400 of the fourth embodiment shown in FIG.8.

Signal detection section 501 detects output signal Srf of combining circuit 105. Signal detection section 501 may be implemented using a directional coupler or circulator.

BPF502 limits the band of the detection signal at signal detection section 501 and only outputs components, which are corresponding to the leakage of the local signal, to mixer 503. Mixer 503 carries out frequency conversion by mixing signals band-limited by BPF 502 with a signal generated by local oscillator 504. A/D converter 505 converts a signal frequency-converted by mixer 503 from analog to digital signals.

Level detection section 506 detects a level of the leakage of the local signal, from a signal analog-to-digital-converted by A/D converter 505. Level detection section 506 can be implemented using a digital signal processing circuit such as anASIC or FPGA together with a diode detector or A/D converter 505. Phase control section 507 controls adjustment of an amount of phase-change at variable phase-shifters 401a, 401b in such a manner that a level detected by level detection section 506 is minimized. Phase control section 507 can be implemented using digital signal processing circuits such as ASIC and FPGA.

Next, anoperationof amplifier circuit 500 having the above configuration is described.

In amplifier circuit 500, output signal Srf from combining circuit 105 is detected by signal detection section 501. Components other than the leakage of the local signal are then suppressed by BPF 502. The leakage of the local signal is then frequency-converted at mixer 503 and converted to a digital signal at A/D converter 505. At level detection section 506, the level of the leakage of the local signal that has become a digital signal is detected and the detection result is outputted to phase control section 507.

In the event that the amount of phase-change fluctuates with time due to an influence exerted by e.g. temperature between two paths through which the local signal passes (i.e. paths from local oscillator 106 through mixers 103a, 103b to combining circuit 105), the phase difference between the leakages of local signal LOa and local signal LOb is no longer 180° and the amount of the error fluctuates. In the event that an error in phase difference occurs, compared to the case where there is no error, the level of the leakage of the local signal becomes large after output from combining circuit 105. Therefore, at phase control section 507, the amount of change of phase by variable phase-shifters 401a, 401b is controlled in such a manner that the level of this leakage is minimized.

According to this embodiment, adjustment of the amount of phase-change by variable phase-shifters 401a, 401b is controlled in such a manner that the level of the leakage of the local signal is minimized. Therefore, even if the phase difference between the local signals after passing through two paths changes with time, it is possible to reduce the error in this phase difference and to prevent lowering of the amount of suppression of the local signal.

(Sixth Embodiment)

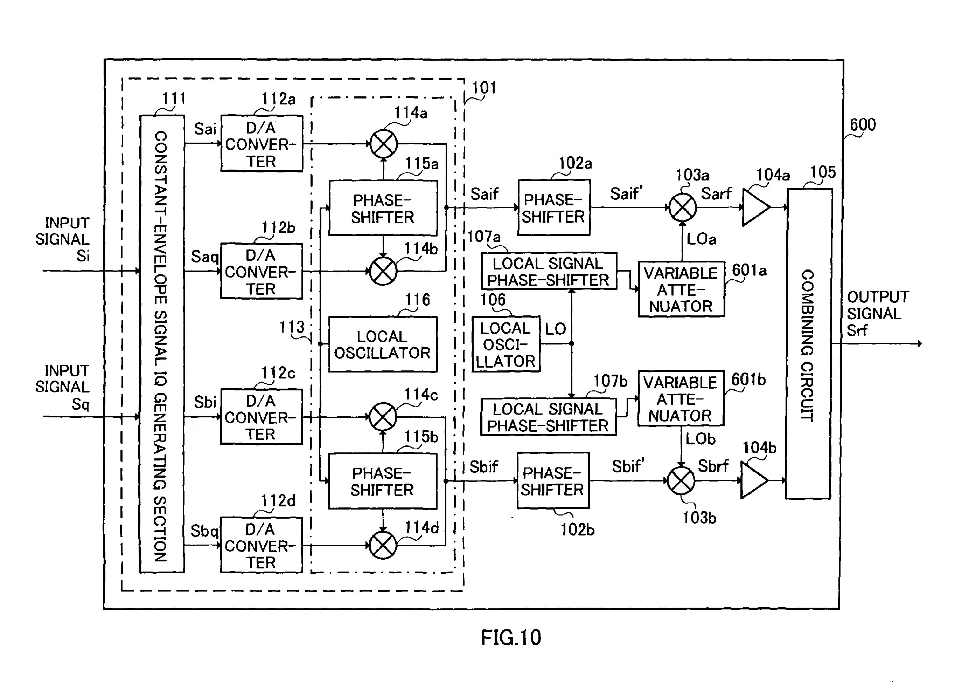

FIG.10 is a block diagram showing a configuration for an amplifier circuit of a sixth embodiment of the present invention. The amplifier circuit described in this embodiment has a basic configuration similar to amplifier circuit 100 described in the first embodiment, the same reference numerals are assigned to the same structural elements, and detailed description thereof is therefore omitted.

Amplifier circuit 600 shown in FIG.10 adopts a configuration where variable attenuator 601a is provided between local signal phase-shifter 107a and mixer 103a of amplifier circuit 100 shown in FIG.4 and variable attenuator 601b is provided between local signal phase-shifter 107b and mixer 103b of amplifier circuit 100.

Variable attenuators 601a, 601b adjust an amplitude (for example, the amount of attenuation) of local signals LOa, LOb and output the results to mixer 103a, 103b, respectively.

Next, anoperationof amplifier circuit 600 having the above configuration is described.

In the event that there is a difference in the amount of attenuation or the amount of amplification between two paths (i.e. paths from local oscillator 106 through mixers 103a, 103b to combining circuit 105), an error occurs in the amplitude of the leakages of local signal LOa and local signal LOb, which results in lowering of the amount of suppression of the leakages of the local signals. Variable attenuators 601a, 601b therefore reduce the amplitude error of the leakage of the local signal by carrying out adjustment of the amount of attenuation of the local signal.

According to this embodiment, by adjusting the amplitude (the amount of attenuation) of the local signal used in frequency conversion at mixers 103a, 103b, it is possible to reduce an amplitude error of the leakages of the local signals due to a difference in the amount of attenuation/amplification in the paths through which the local signals pass, and it is possible to prevent lowering of the amount of suppression of the leakages of local signals.

In this embodiment, a description is given of a configuration where variable attenuators 601a, 601b are arranged between local signal phase-shifters 107a, 107b and mixers 103a, 103b but the configuration of amplifier circuit 600 is by no means limited to this respect. For example, it is also possible to achieve the same operation and effect as above by providing items executing the same operation as variable attenuators 601a, 601b between local oscillator 106 and local signal phase-shifters 107a, 107b, between mixers 103a, 103b and combining circuit 105 or within combining circuit 105.

(Seventh Embodiment)

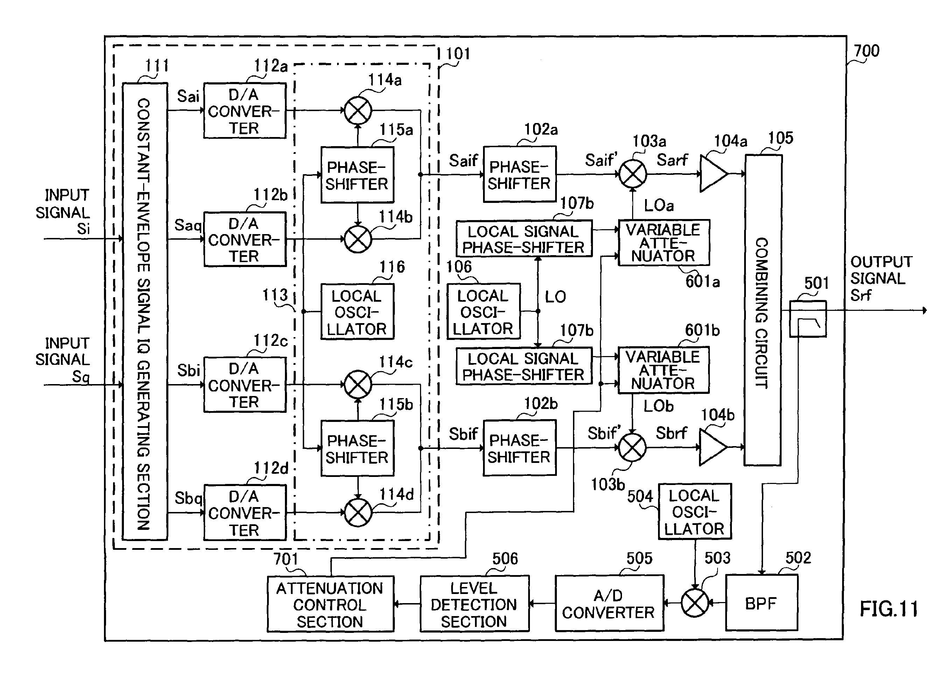

FIG.11 is a block diagram showing a configuration for an amplifier circuit of a seventh embodiment of the present invention. The amplifier circuit described in this embodiment has a basic configuration similar to amplifier circuit 100 described in the first embodiment, the same reference numerals are assigned to the same structural elements, and detailed description thereof is therefore omitted.

Amplifier 700 shown in FIG.11 adopts a configuration where signal detecting section 501, BPF 502, mixer 503, local oscillator 504, A/D converter 505, and level detection section 506 described for the fifth embodiment and attenuation control section 701 are added to the configuration for amplifier circuit 600 of the sixth embodiment shown in FIG.10.

Signal detection section 501 detects output signal Srf of combining circuit 105. Signal detection section 501 may be implemented using a directional coupler or circulator.

Attenuation control section 701 controls adjustment of the amplitude (for example, the amount of attenuation) at variable attenuators 601a, 601b in such a manner that a level detected by level detection section 506 is minimized. Attenuation control section 701 can be implemented using digital signal processing circuits such as ASIC and FPGA.

Next, an operation of amplifier circuit 700 having the above configuration is described.

At amplifier circuit 700, output signal Srf from combining circuit 105 is detected by signal detection section 501. Components other than the leakage of the local signal are then suppressed by BPF 502. The leakage of the local signal is then frequency-converted at mixer 503 and converted to a digital signal at A/D converter 505. At level detection section 506, the level of the leakage of the local signal that has become a digital signal is detected and the detection result is outputted to attenuation control section 701.

In the event that the amount of attenuation or amplification fluctuates with time due to an influence exerted by e.g. temperature between two paths through which the local signal passes (i.e. paths from local oscillator 106 through mixers 103a, 103b to combining circuit 105), an error occurs in the amplitude of the leakages of local signal LOa and local signal LOb, and this amplitude error fluctuates with time. In the event that an amplitude error occurs, compared to the case where there is no error, the level of the leakage of the local signal becomes large after output from combining circuit 105. Therefore, at attenuation control section 701, the amplitude (the amount of attenuation) is controlled by variable attenuators 601a, 601b in such a manner that the level of this leakage is minimized.

According to this embodiment, adjustment of the amplitude (the amount of attenuation) by variable attenuators 601a, 601b is controlled in such a manner that the level of the leakage of the local signal is minimized. Therefore, even if the amplitude error of the local signals passing through two paths fluctuates with time, it is possible to reduce the amplitude error and it is possible to prevent lowering of the amount of suppression of the local signal.

(Eighth Embodiment)

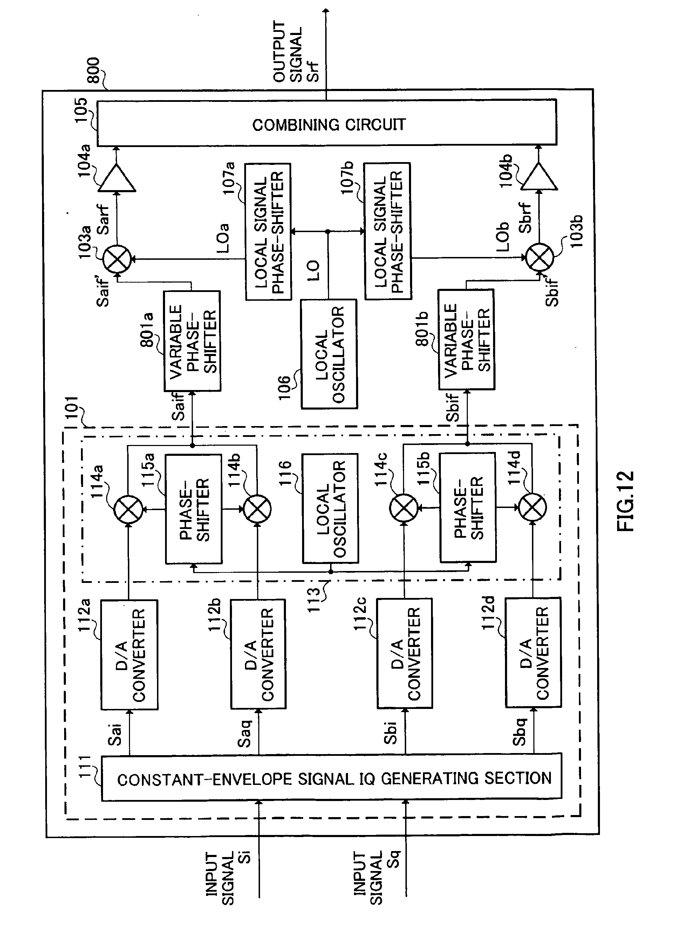

FIG.12 is a block diagram showing a configuration for an amplifier circuit of an eighth embodiment of the present invention. The amplifier circuit described in this embodiment has a basic configuration similar to amplifier circuit 100 described in the first embodiment, the same reference numerals are assigned to the same structural elements, and detailed description thereof is therefore omitted.

Amplifier circuit 800 shown in FIG.12 adopts a configuration where variable phase-shifters 801a, 801b are provided in place of phase-shifters 102a, 102b of amplifier circuit 100 shown in FIG.4.

Variable phase-shifters 801a, 801b differ from phase-shifters 102a, 102b in having a function to adjust an amount of phase-change of first constant-envelope signal Saif and second constant-envelope signal Sbif.

Next, an operation of amplifier circuit 800 having the above configuration is described.

Two local signals LOa, LOb used by mixers 103a, 103b have a phase difference of 180°, and first constant-envelope signal Saif' and second constant-envelope signal Sbif' have a phase difference of 180°, so that the original phase is restored after being frequency-converted to the carrier frequency. However, in the event that there is a difference in an electrical length between two paths through which the constant-envelope signals pass (namely, paths from constant-envelope signal generating section 101 to mixers 103a, 103b), or in the event that there is a difference in the amount of phase-change by mixers 103a, 103b, a phase difference error still remains after frequency conversion, and the transmission signal after combining may be distorted. Therefore, at variablephase-shifters 801a, 801b, it is possible to reduce the phase difference error by adjusting the amount of phase-change and reduce the distortion of the transmission signal after combining.

According to this embodiment, adjusting the amount of phase-change of the constant-envelope signals before frequency-converted at mixers 103a, 103b makes it possible to reduce an error in a phase difference due to an electrical length difference or the like in paths through which the constant-envelope signals pass, and also makes it possible to reduce the distortion of a transmission signal after combining.

In this embodiment, a description is given of a configuration for adjusting the amount of phase-change of each constant-envelope signal using variable phase-shifters 801a, 801b, but the configuration of amplifier circuit 800 is bynomeans limitedto this respect. For example, in the event of changing phase of constant-envelope signals within constant-envelope signal generating section 201 as described in the second embodiment, it is possible to obtain the same operation and effect by changing and adjusting the phase using digital signal processing.

(Ninth Embodiment)

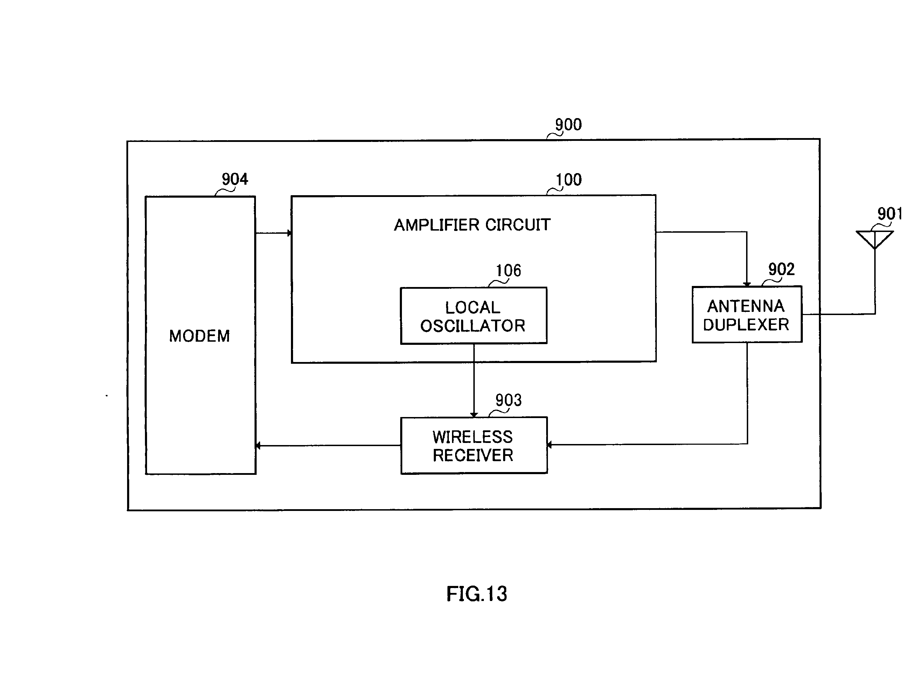

FIG.13 is a block diagram showing a configuration for a wireless transceiver apparatus of a ninth embodiment of the present invention. Wireless transceiver apparatus 900 shown in FIG.13 is comprised of amplifier circuit 100 described in the first embodiment, antenna 901 transmitting and receiving wireless signals, antenna duplexer 902 duplexing transmission and reception at antenna 901, outputting an output signal of amplifier circuit 100 to antenna 901, and outputting signals received by antenna 901 to wireless receiver 903, wireless receiver 903 comprisedof a circuit (a lownoise amplifier, mixer performing frequency conversion, filter, variable gain amplifier, A/D converter, or the like) extracting desired reception signals from an output signal of antenna duplexer 902, and modem 904 modulating audio, video and data signals or the like to signals to be transmitted wirelessly, and demodulating audio, video and data signals or the like from signals received wirelessly.

Wireless transceiver apparatus 900 may also adopt a configuration having any of amplifier circuit 200 to amplifier circuit 800 described in the second embodiment to eighth embodiment, respectively, inplaceof amplifier circuit 100.

Wireless transceiver apparatus 900 of this embodiment uses an amplifier circuit as described in any of the embodiments described above for amplifying the transmission signal.

According to this embodiment, it is possible to implement wireless transceiver apparatus 900 achieving the same operation and effect as the operation and effect described above in any of the first to eighth embodiments.

The wireless transceiver apparatus 900 described in the above embodiments may be applied to a wireless base station apparatus or communication terminal apparatus used in a wireless communication and broadcast network.

(Tenth Embodiment)

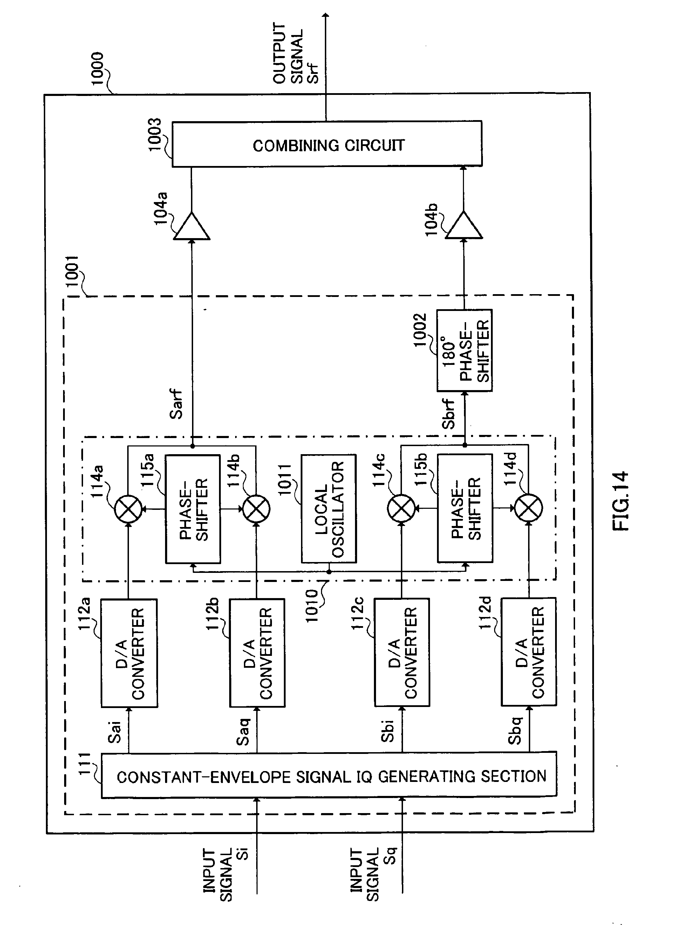

FIG.14 is a block diagram showing a configuration for an amplifier circuit of a tenth embodiment of the present invention. The amplifier circuit described in this embodiment has a basic configuration similar to amplifier circuit 100 described in the first embodiment, the same reference numerals are assigned to the same structural elements, and detailed description thereof is therefore omitted.

Amplifier circuit 1000 shown in FIG.14 has constant-envelope signal generating section 1001 and combining circuit 1003 in place of constant-envelope signal generating section 101 and combining circuit 105 of amplifier circuit 100 shown in FIG.4. Phase-shifters 102a, 102b, mixers 103a, 103b, local oscillator 106 and local signal phase-shifters 107a, 107b of amplifier circuit 100 are not provided at amplifier circuit 1000.

Constant-envelope signal generating section 1001 has orthogonal modulator 1010 in place of orthogonal modulator 113 described in the first embodiment. 180° phase-shifter 1002 is also provided. Constant-envelope signal generating section 1001 may also be implemented using a digital signal processing circuit such as an ASIC or FPGA.

In addition to mixers 114a to 114d and phase-shifters 115a, 115b described in the first embodiment, local oscillator 1011 is also provided in orthogonal modulator 1010. Orthogonal modulator 1010 orthogonally modulates baseband signals Sai, Saq, Sbi, Sbq to generate first constant-envelope signal Sarf and second constant-envelope signal Sbif respectively described in the first embodiment.

Local oscillator 1011 in orthogonal modulator 1010 is, for example, an oscillator circuit such as a frequency synthesizer or the like employing a VCO controlled using a PLL, generates local signal LO, and outputs this to phase-shifters 115a, 115b. Baseband signals Sai, Saq, Sbi, Sbq are frequency-converted by mixing local signal LO generated by local oscillator 1011 with baseband signals Sai, Saq, Sbi, Sbq at mixers 114a to 114d. In this way, baseband signals Sai, Saq are directly converted to first constant- envelope signal Sarf having carrier frequency $\omega$arf, and baseband signals Sbi, Sbq are directly converted to second constant-envelope signal Sbif having carrier frequency $\omega$rf. Generated first constant-envelope signal Sarf is outputted to amplifier 104a described in the first embodiment and generated second constant-envelope signal Sbrf is outputted to 180° phase-shifter 1002.

180° phase-shifter 1002 changes the phase of second constant-envelope signal Sbrf by 180°. Second constant-envelope signal Sbrf after phase-shifting by 180° is output to amplifier 104b as described in the first embodiment.

Combining circuit 1003 shifts by 180° the phase of one of first constant-envelope signal Sarf and second constant-envelope signal Sbrf amplified by amplifiers 104a, 104b, and performs vector-combining of first constant-envelope signal Sarf and second constant-envelope signal Sbrf. Output signal Srf which is a signal outputted by amplifier circuit 1000 is then generated as a result. Combining circuit 1003 can be implemented, for example, by a 180° hybrid combining circuit configured by microstrip lines or by a balan.

Next, an operation of amplifier circuit 1000 having the above configuration is described.

In constant-envelope signal IQ generating section 111, baseband signals Sai, Saq, Sbi, Sbq expressed by (equation 23) to (equation 26) described above are generated from input signal S (t) shown by the following (equation 31).

$$S(t) = Vmax/2 \cdot \cos(\omega ift + \psi(t))$$

$$+ Vmax/2 \cdot \cos(\omega ift + \theta(t)) ... (equation\ 31)$$

Baseband signals Sai, Saq, Sbi, Sbq are converted to analog signals by D/A converters 112a to 112d, and first constant-envelope signal Sarf and second constant-envelope signal Sbrf are generated by orthogonal modulation at orthogonal modulator 1010. Here, first constant-envelope signal Sarf and second constant-envelope signal Sbrf will constitute a signal turning to the original signal when subjected to vector combining.

Second constant-envelope signal Sbrf is phase-shifted by 180° by 180° phase-shifter 1002. First constant-envelope signal Sarf and second constant-envelope signal Sbrf outputted by constant-envelope signal generating section 1001 are therefore shown by the following (equation 32) and (equation 33).

$$Sarf = Vmax/2 \cdot \cos(\omega rft + \psi(t)) ... (equation\ 32)$$

$$Sbrf=Vmax/2 \cdot cos(\omega rft+\theta(t)-180°) \ldots (equation\ 33)$$

180° phase-shifting at 180° phase-shifter 1002 can be implemented using digital signal processing. In this case, baseband signals Sai, Saq, Sbi, Sbq are generated using the following (equation 34) (equation 35) and (equation 36) at constant-envelope signal IQ generating section 111.

$$Sai=((I-Q \cdot SQRT(x/a^2-1)) \ldots (equation\ 34)$$

$$Saq=((Q+I \cdot SQRT(x/a^2-1)) \ldots (equation\ 35)$$

$$Sbi=((Q \cdot SQRT(x/a^2-1)-I) \ldots (equation\ 36)$$

$$Sbq=((I \cdot SQRT(x/a^2-1)-Q) \ldots (equation\ 37)$$

In amplifiers 104a, 104b, first constant-envelope signal Sarf and second constant-envelope signal Sbrf outputted from constant-envelope signal generating section 1001 are amplified. Assuming a gain of amplifier 104a, 104b to be G, first constant-envelope signal Sarf and second constant-envelope signal Sbrf are shown by (equation 38) and (equation 39), respectively.

$$Sarf=G \cdot Vmax/2 \cdot cos((\omega rft+\psi(t)) \ldots (equation\ 38)$$

$$Sbrf=G \cdot Vmax/2 \cdot cos((\omega rft+\theta(t)-180°) \ldots (equation\ 39)$$

In synthesis circuit 1003, the phase of second constant-envelope signal Sbrf after amplification is shifted by 180°, and first constant-envelope signal Sarf and second constant-envelope signal Sbrf after amplification are combined. Output signal Srf obtained by combining is shown by the following (equation 40).

$$Srf=G \cdot Vmax/2 \cdot cos((\omega rft+\psi(t))$$
$$+G \cdot Vmax/2 \cdot cos((\omega rft+\theta(t)-180°+180°)$$
$$=G \cdot V(t)cos(\omega rft+\varphi(t)) \ldots (equation\ 40)$$

In combining circuit 1003, when amplified first constant-envelope signal Sarf and amplified second constant-envelope signal Sbrf are combined after the phase of amplified first constant-envelope signal Sarf is shifted by 180°, output signal Srf obtained by combining is shown by the following (equation 41).

$$Srf=G \cdot Vmax/2 \cdot \cos((\omega rft+\psi(t)+180°)$$

$$+G \cdot Vmax/2 \cdot \cos((\omega rft+\theta(t)-180°)$$

$$=G \cdot V(t)\cos(\omega rft+\varphi(t)-180°)...(equation \ 41)$$

Here, noise mixed between constant-envelope signal generating section 1001 and combining circuit 1003 is assumed to be Sn. In amplifier circuit 1000 of this embodiment, it is possible to cancel out this noise Sn by vector combining at combining circuit 1003. This can be expressed in the following equations.

Noise entering into first constant-envelope signal Sarf is assumed to be Sna, and noise entering into second constant-envelope signal Sbrf is assumed to be Snb. Noise Sna, Snb can be expressed using (equation 42) and (equation 43), respectively.

$$Sna=Vn \cdot \cos(\omega nt)...(equation \ 42)$$

$$Snb=Vn \cdot \cos(\omega nt)...(equation \ 43)$$

In combining circuit 1003, when noise Snb out of noise Sna and noise Snb is phase-shifted by 180°, a noise component Snout contained in output signal Srf after vector combining can be expressed using the following (equation 44).

$$Snout=Vn \cdot \cos(\omega nt)+Vn \cdot \cos(\omega nt+180°)=0...(equation \ 44)$$

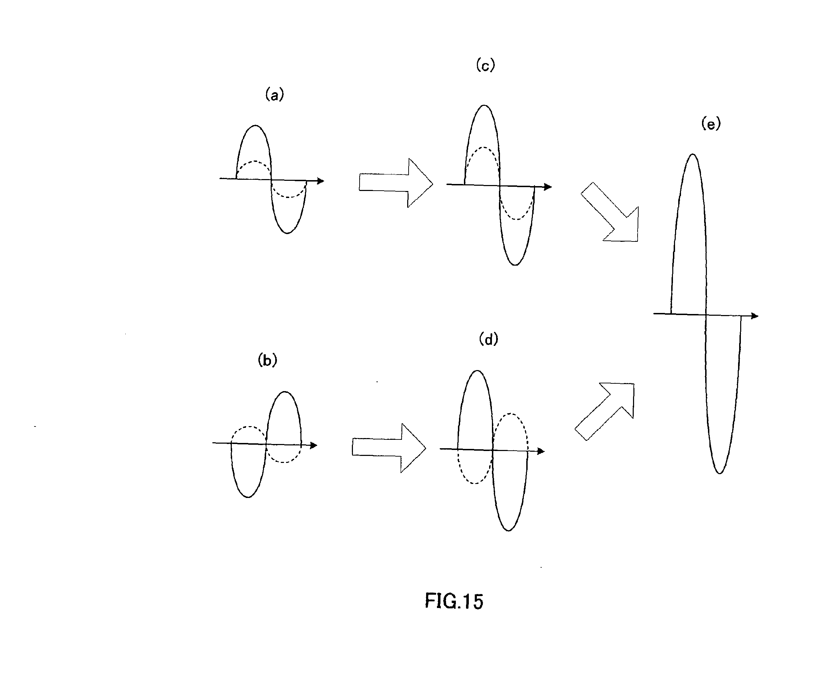

FIG.15 shows a signal waveform obtained at each processing stage within amplifier circuit 1000 as triangular waves. The waveform shown by the solid line in (a) is a waveform of first constant-envelope signal Sarf outputted from constant-envelope signal generating section 1001, and the waveform shown by the dashed line in (a) is a waveform of noise Sna. Further, the waveform shown by the solid line in (b) is a waveform of second constant-envelope signal Sbrf outputted by constant-envelope signal generating section 1001, and the waveform shown by the dashed line in (b) is a waveform of noise Snb. Noise Sna and noise Snb is of the same phase. Each signal waveform at the time of combining is as shown in (c) and (d).

Namely, constant-envelope signal Saft shown by the solid line in (c) and noise Sna shown by the dashed line are signals obtained by amplifying the constant-envelope signal Sarf and noise Sna shown in (a). On the other hand, constant-envelope signal Sbrf shown by the solid line in (d) and noise Snb shown by the broken line are signals obtained by amplifying constant-envelope signal Sbrf and noise Snb shown by (b) and rotating the phases at combining circuit 1003 by 180°. Accordingly, in the signal after combining shown in (e), noise Sna and Snb mutually cancels each other out.

According to this embodiment, constant-envelope signal generating section 1001 generates two constant-envelope signals Sarf, Sbrf such that an original signal can be obtained by changing the phase of one of constant-envelope signals Sarf, Sbrf and then combining those signals, and combining circuit 1003 changes the phase of one of constant-envelope signals Sarf, Sbrf, and thereby the waveform of output signal Srf is an amplified version of the original input signal S (t) . Further, it is possible to remove noise Sna, Snb, and prevent deterioration in the communication quality due to noise.

(Eleventh Embodiment)

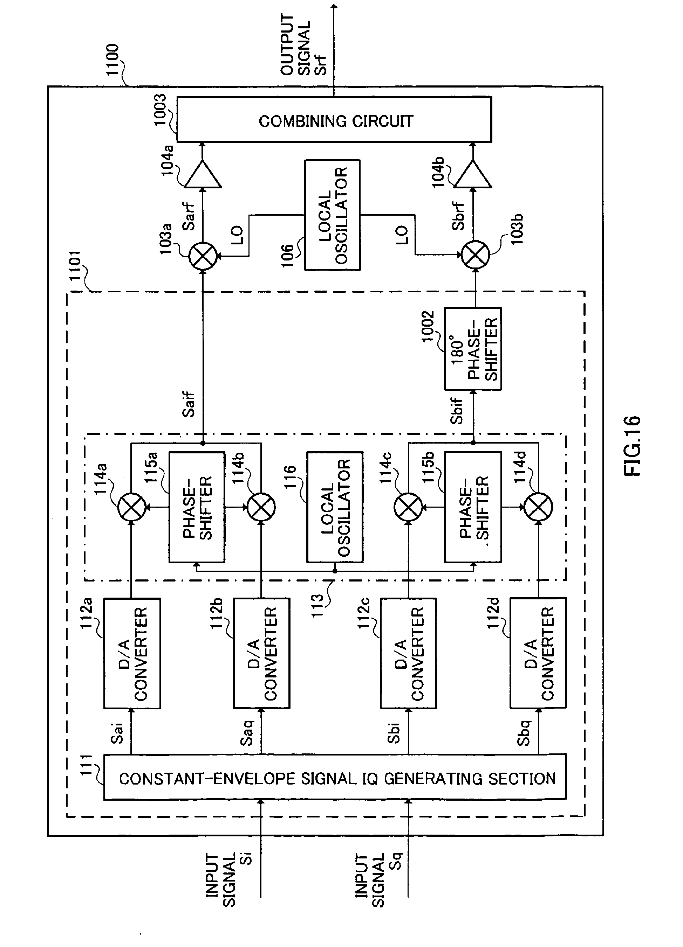

FIG.16 is a block diagram showing a configuration for an amplifier circuit of an eleventh embodiment of the present invention. The amplifier circuit described in this embodiment has a basic configuration similar to amplifier circuit 100 described in the first embodiment, the same reference numerals are assigned to the same structural elements, and detailed description thereof is therefore omitted.

Amplifier circuit 1100 shown in FIG.16 has constant-envelope signal generating section 1101 in place of constant-envelope signal generating section 101 of amplifier circuit 100. Further, combining circuit 1003 described in the tenth embodiment is provided in place of combining circuit 105. Phase-shifters 102a, 102b and local signal phase-shifters 107a, 107b of amplifier circuit 100 are not provided in amplifier circuit 1100.

In addition to constant-envelope signal IQ generating section 111 of constant-envelope signal generating section 101, D/A converters 112a to 112d and orthogonal modulator 113, constant-envelope signal generating section 1101 has 180° phase-shifter 1002 described in the tenth embodiment. Constant-envelope signal generating section 1101 may also be implemented using a digital signal processing circuit such as an ASIC or FPGA.

An operation of amplifier circuit 1100 having the above configuration is described.

First, in constant-envelope signal generating section 1101, at orthogonal modulator 113, first constant-envelope signal Saif and second constant-envelope signal Sbif are generated. The phase of second constant-envelope signal Sbif is phase-shifted by 180° by 180° phase-shifter 1002. First constant-envelope signal Saif is then outputted to mixer 103a. Second constant-envelope signal Sbif after phase shifting is outputted to mixer 103b.

At mixer 103a, 103b, local signal LO generated at local oscillator 106 is mixed with first constant-envelope signal Saif and second constant-envelope signal Sbif. As a result, first constant-envelope signal and second constant-envelope signal Sbif are frequency-converted and first constant-envelope signal Sarf and second constant-envelope signal Sbrf are obtained.

At this time, leakage of local signal LO occurs at the outputs of mixers 103a, 103b. The leakage of the local signals can be expressed by the following (equation 45) and (equation 46) . SLO_outa is the leakage included in first constant-envelope signal Sarf and SLO_outb is the leakage included in second constant-envelope signal Sbrf.

$$\mathrm{SLO\_outa=VLO\_out \cdot cos(\omega nt)} \quad \ldots \quad \mathrm{(equation\ 45)}$$

$$\mathrm{SLO\_outb=VLO\_out \cdot cos(\omega nt)} \quad \ldots \quad \mathrm{(equation\ 46)}$$

At combining circuit 1003, signals inputted from amplifiers 104a, 104b are subjected to vector combining after the phase of signals inputted from amplifier 104b is shifted by 180°. As a result, the leakage of local signals LO contained in output signal Srf after combining can be expressed by the following (equation 47).

$$\mathrm{SLO\_out=VLO\_out \cdot cos(\omega nt)+VLO\_out \cdot cos(\omega nt+180°)=0}$$
$$\mathrm{...(equation\ 47)}$$

According to this embodiment, constant-envelope signal generating section 1101 generates two constant-envelope signals Sarf, Sbrf such that an original signal can be obtained by changing the phase of one of constant-envelope signals Sarf, Sbrf and then combining those signals, and combining circuit 1003 changes the phase of one of constant-envelope signals Sarf, Sbrf, and thereby the waveform of output signal Srf is an amplified version of the original input signal S(t). Further, it is possible to suppress spurious components due to leakage of local signals LO. As to mixed noise, because of the same operation as that of the tenth embodiment, it is possible to suppress the noise and prevent deterioration of the communication quality.

Amplifier circuit 1100 of this embodiment can be applied to wireless transceiver apparatus 900 described in the ninth embodiment.

(Twelfth Embodiment)

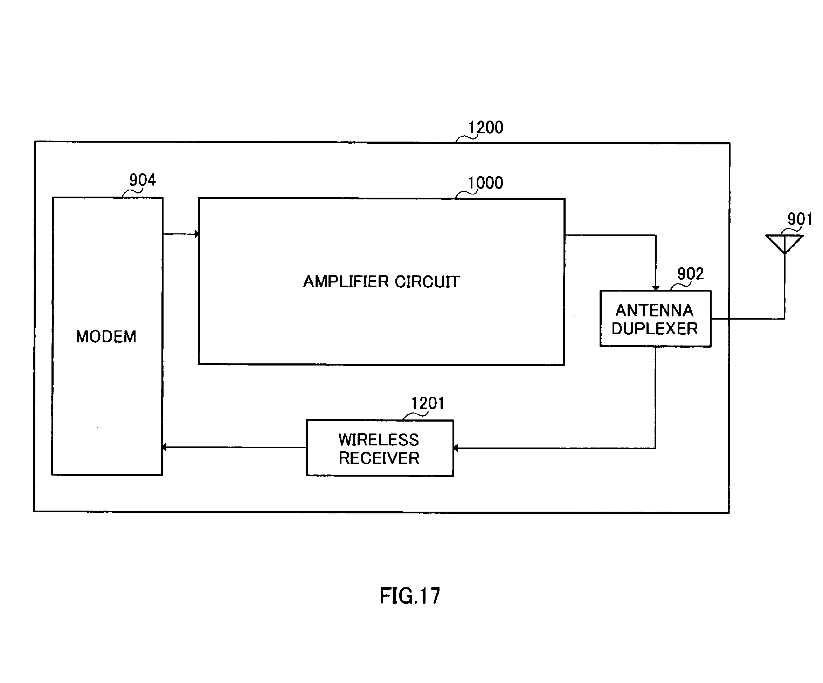

FIG.17 is a block diagram showing a configuration for a wireless transceiver apparatus of a twelfth embodiment of the present invention. The wireless transceiver apparatus described in this embodiment has a basic configuration similar to wireless transceiver apparatus 900 described in the ninth embodiment, the same reference numerals are assigned to the same structural elements, and detailed description thereof is therefore omitted.

Wireless transceiver apparatus 1200 shown in FIG.17 has amplifier circuit 1000 described in the tenth embodiment, antenna 901, antenna duplexer 902, and modem 904 described in the ninth embodiment, and wireless receiver 1201.

Wireless receiver 1201 is a circuit for extracting a desired reception signal from an output signal of antenna duplexer 902, and is configured from, for example, a low noise amplifier, a mixer for frequency conversion, a filter, a variable gain amplifier, and an A/D converter or the like.

According to this embodiment, it is possible to implement wireless transceiver apparatus 1200 achieving the same operation and effect as the operation and effect described above in the tenth embodiment.

Wireless transceiver apparatus 1200 in the above embodiment may be applied to a wireless base station apparatus or communication terminal apparatus used in a wireless communication and broadcast network.

This specification is based on Japanese patent application No. 2003-359440 filed on October 20th, 2003, and Japanese patent application No. 2004-302792 filed on October 18th, 2004, the entire contents of which are expressly incorporated by reference herein.

Industrial Applicability

The amplifier circuit of the present invention has the effect of improving communication quality with high power efficiency and is useful as an amplifier circuit in a later stage amplifying a transmission signal in a transmissionapparatusemployed,forexample,in wireless communication and broadcasting.

**Claims**

1. An amplifier circuit comprising:

   a generating section that generates a first local signal and a second local signal which are used in frequency conversion of a first constant-envelope signal and a second constant-envelope signal having respective predetermined phases, the first local signal and the second local signal having a 180° phase difference therebetween;
   a frequency conversion section that performs frequency-conversion of the first constant-envelope signal and the second constant-envelope signal using the generated first local signal and second local signal;
   an amplifying section that amplifies the frequency-converted first constant-envelope signal and second constant-envelope signal; and
   a combining section that combines the amplified first constant-envelope signal and second constant-envelope signal.

2. The amplifier circuit according to claim 1, further comprising a local signal phase adjustment section that adjusts a phase of at least one of the generated first local signal and second local signal.

3. The amplifier circuit according to claim 2, further comprising: a detecting section that detects a level of leakage of the local signals in an output signal obtained as a result of combining by the combining section; and a phase control section that controls the local signal phase adjustment section in such a manner that the detected level is minimized.

4. The amplifier circuit according to claim 1, further comprising a local signal amplitude adjustment section that adjusts an amplitude of at least one of the generated first local signal and second local signal.

5. The amplifier circuit according to claim 4, further comprising: a detecting section that detects a level of leakage of the local signals in an output signal obtained as a result of combining by the combining section; and an amplitude control section that controls the local signal amplitude adjustment section in such a manner that the detected level is minimized.

6. The amplifier circuit according to claim 1, further comprising a constant-envelope signal phase adjustment section that adjusts a phase of at least one of the frequency-modulated first constant-envelope signal and second constant-envelope signal.

7. A wireless base station apparatus comprising the amplifier circuit according to claim 1.

8. A wireless terminal apparatus comprising the amplifier circuit according to claim 1.

PRIOR ART

FIG.1

PRIOR ART

FIG.2

PRIOR ART

FIG.3

EP 1 677 417 A1

FIG.4

FIG.5A

FIG.5B

FIG.5C

FIG.6

FIG.7

FIG.8

FIG.9

FIG.10

FIG.11

FIG.12

FIG.13

FIG.14

FIG.15

FIG.16

FIG.17

EP 1 677 417 A1

# EP 1 677 417 A1

## INTERNATIONAL SEARCH REPORT

| | International application No. |
|---|---|
| | PCT/JP2004/015534 |

A. CLASSIFICATION OF SUBJECT MATTER
      Int.Cl⁷  H03F3/24, H04B1/04

According to International Patent Classification (IPC) or to both national classification and IPC

B. FIELDS SEARCHED

Minimum documentation searched (classification system followed by classification symbols)
      Int.Cl⁷  H03F3/24, H04B1/04

Documentation searched other than minimum documentation to the extent that such documents are included in the fields searched
      Jitsuyo Shinan Koho          1922-1996    Toroku Jitsuyo Shinan Koho   1994-2004
      Kokai Jitsuyo Shinan Koho    1971-2004    Jitsuyo Shinan Toroku Koho   1996-2004

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2003-298357 A  (SPC Electronics Corp.), 17 October, 2003 (17.10.03), Par Nos. [0020] to [0052]; Figs. 2, 3 (Family: none) | 1-2,4,6-8 |
| Y | JP 10-270947 A  (Ando Electric Co., Ltd.), 09 October, 1998 (09.10.98), Par Nos. [0029] to [0039]; Fig. 4 (Family: none) | 1,2,4,6-8 |
| Y | JP 2001-244752 A  (Nippon Telegraph And Telephone Corp.), 07 September, 2001 (07.09.01), Par Nos. [0043] to [0047]; Figs. 6 to 8 (Family: none) | 1-2,4,6-8 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 18 January, 2005 (18.01.05) | 01 February, 2005 (01.02.05) |

| Name and mailing address of the ISA/ | Authorized officer |
|---|---|
| Japanese Patent Office | |
| Facsimile No. | Telephone No. |

Form PCT/ISA/210 (second sheet) (January 2004)

35

**INTERNATIONAL SEARCH REPORT**

| International application No. |
|---|
| PCT/JP2004/015534 |

C (Continuation).  DOCUMENTS CONSIDERED TO BE RELEVANT

| Category* | Citation of document, with indication, where appropriate, of the relevant passages | Relevant to claim No. |
|---|---|---|
| Y | JP 9-261102 A (Toshiba Corp.),<br>03 October, 1997 (03.10.97),<br>Par No. [0014]; Fig. 1<br>& US 5991612 A | 4 |
| A | JP 2000-209291 A (Hitachi, Ltd.),<br>28 July, 2000 (28.07.00),<br>Par Nos. [0026] to [0032]; Fig. 5; Par Nos.<br>[0037] to [0040]; Fig. 8<br>(Family: none) | 3 |
| A | JP 2002-101000 A (Matsushita Electric<br>Industrial Co., Ltd.),<br>05 April, 2002 (05.04.02),<br>Par Nos. [0021] to [0024]; Fig. 2<br>(Family: none) | 1 |

Form PCT/ISA/210 (continuation of second sheet) (January 2004)